# EUROPEAN PATENT APPLICATION

(11) **EP 1 355 193 A2**
(43) Date of publication of application: **22.10.2003**
(21) Application number: 03008587.2
(22) Date of filing: 14.04.2003
(51) Int. Cl.: G03F 7/029, G03F 7/031

(54) **Photo-curable resin composition**

(30) Priority: 19.04.2002 JP 2002153124
(71) Applicant: Meiko Co., Ltd., Kitakoma-gun, Yamanashi (JP)
(72) Inventor: Hiizumi, Koki, Kitakoma-gun, Yamanashi (JP)
(74) Representative: Kirschner, Klaus Dieter, Dipl.-Phys.

(57) **Abstract**

A photo-curable resin composition for use in optical molding for building up a three-dimensional product by scanning a surface of a liquid photo-curable resin with a beam of radiant energy of suitable intensity and wavelength so as thereby to cure and solidify a liquid layer of the liquid photo-curable resin and forming stacked integrated laminae of cured resin as the three-dimensional product comprises a photo-curable resin material curable, a photo-initiator capable of inducing said photo-curable resin to cause a curing reaction with radiant energy and a fluorescent brightener.

## Description

The present invention relates to a photo-curable resin composition for use in optical molding for building up a three-dimensional product or a copy of the three-dimensional product by scanning a surface of a liquid photo-curable resin with a light beam of radiant energy of suitable intensity and wavelength so as to cure and solidify a liquid layer of the liquid photo-curable resin and forming stacked integrated laminae of cured resin and, more particularly, to a photo-curable resin composition that has superior curing characteristics and is suitable for forming a precise three-dimensional product.

Optical molding techniques have been developed commercially in the past for making three-dimensional products by the use of a photo-curable resin. These optical molding techniques involve irradiating a liquid surface of a liquid photo-curable resin to form a succession of cured resin layers corresponding to successive cross-sectional laminae of a three-dimensional product on top of one another, with all of the cured resin layers integrally laminated together to form a whole solidified three-dimensional product. Each cured is formed by selectively curing a layer of fresh liquid photo-curable resin formed over a cured resin layer with a beam of radiant energy of suitable intensity and wavelength. Such an optical molding apparatus and method for producing three-dimensional products by the use of a photo-curable resin and their improvements are described in, for example, Japanese Unexamined Patent Publication Nos. 56-144478, 6-228413, 6-228271 and Japanese Patent No. 3117394.

An exemplification of such an optical molding process involves forming a thin liquid layer of photo-curable resin of a specified thickness over a cured resin layer, selectively scanning the thin liquid layer with a beam of radiant energy of suitable intensity and wavelength using, for example, a computer-controlled ultraviolet radiation laser to obtain a cured resin layer on the preceding cured resin layer. These processes are successively repeated a number of times to build up a three-dimensional product. The optical molding apparatus and method is almost always programmed to automatically make a three-dimensional product by drawing its various cross-sections, one layer at a time, and building the three-dimensional product up layer-by-layer. The optical molding apparatus is easily linked to a computer aided design as a computer aided manufacturing (CAD/CAM) apparatus.

In recent years, the optical molding is widely used to produce models such as burn-off molds for casting, simple molds for casting, prototypes of molds for casting, master molds, prototypes of products for early optimization, visualization and verification. Consequentially, it is needed to fulfill the high precision requirement of three-dimensional products.

Useful photo-curable resins that meet the high dimensional requirement have been proposed in, for example, Japanese Unexamined Patent Publication Nos. 3-15520, 3-41126 and 3-114733. Such a photo-curable resin contains a material that is operative to deflect or scatter ultraviolet radiation coming in a liquid of the photo-curable resin liquid in a direction of radiation (a Z direction) radially so as thereby to effect regulation of a penetration depth of the ultraviolet radiant energy and equalization of the ultraviolet radiant energy in radial directions. The photo-curable resin further contains an ultraviolet absorption material that is operative to absorb a redundant part of the ultraviolet radiant energy so as thereby to form a precise thickness of cured resin layer, and hence to a whole solidified three-dimensional product with a high precision in height made up of the cured resin layers integrally laminated together.

However, in the case of using the photo-curable resin with a radiation scattering or deflection material contained therein that is useful for forming individual cured layers precisely controlled in thickness, in order for the photo-curable resin to cause reliably controlled scattering or deflection of the ultraviolet radiation, it is essential for the radiation scattering or deflection material to have deflection or scattering planes directed at substantially identical angles with respect to the direction of radiation. If the deflection or scattering material has deflection or scattering planes different in angle from one another with respect to the direction of radiation, the ultraviolet radiation reflects diffusely on the deflection or scattering planes. Therefore, it is conceivably difficult to control curing dimensions, e.g. depth (in Z direction) and widths (in X and/or Y directions) even while it is enabled to control a depth of penetration of the ultraviolet radiation.

On the other hand, in the case of using the photo-curable resin with an ultraviolet absorption material contained therein, it is essential for the photo-curable resin in liquid form to be exposed to radiation at wavelengths less than approximately 400 nm, more specifically at wavelengths ranging from 300 nm to 350 nm, and to absorb the radiant energy sufficiently to cure and solidify. For example, in the case where the liquid photo-curable resin in liquid form is exposed to radiation of a wavelength in an ultraviolet range longer than 350 nm, and more strictly longer than 380 nm, or of a wavelength in a visible range longer than 400 nm, or of wavelengths in both ultraviolet and visible ranges, or exposed to radiation at wavelengths in the visible range longer than 400 nm all at once, part of the radiant energy that is at wavelengths longer than 380 nm is not contributory to the control of curing depth (in Z direction) and curing widths (in X and/or Y directions) of a thin liquid layer of photo-curable resin.

In this type of conventional optical molding process for producing three-dimensional products by the use of photo-curable resins, an ultraviolet radiation laser has been widely used as a radiant energy source. This is because the ultraviolet laser produces radiant energy of high intensity and single wavelength for curing a liquid layer of the photo-curable resin in liquid form. Furthermore, because the conventional photo-curable resins in liquid form are insensitive or unreactive to radiation in the visible range, the ultraviolet laser is conveniently used as a radiant energy source in terms of handling the photo-curable resins in liquid form. On the other hand, ultraviolet lasers are expensive in many instances and under the necessity of being accompanied by an incidental cooling equipment depending on the varieties. This is one of real and substantive factors standing in the way of downsizing and price-reduction of the photo-molding apparatus for making three-dimensional products by the use of photo-curable resins. In light of this problem, it is conceivably useful to use a mercury lamp capable of producing ultraviolet radiation or a laser diode (LD) capable of producing visible radiant energy (light) as a radiant energy source that have been well-adaptable for inexpensive production on a large scale.

When offering a downsized and price-reduced optical molding apparatus for making precise three-dimensional products by the use of photo-curable resins, it is essential in terms of price of a radiant energy source to employ an ultraviolet lamp that produces ultraviolet radiation or a laser diode operative to produce visible radiation. Ultraviolet lamps produce ultraviolet radiation and light whose wavelengths other than those in the ultraviolet range. On the other hand, the visible radiation laser diodes produce radiant energy whose intensity is significantly lower than an intensity of radiant energy of the light produced by the ultraviolet lamps. Accordingly, both ultraviolet lamps and visible radiation laser diodes are unsuitable for ultraviolet-curable resins. In particular, in the case where the visible radiation laser diode is used as a radiant energy source, in order for a photo-initiator to cause sufficient absorption of radiant energy, the photo-initiator must have a wavelength range of absorption shifted more toward the visible range as the wavelength of light produced by the visible radiation laser diode becomes longer. This results in that a liquid photo-curable resin containing such a photo-initiator is too sensitive to radiant energy, in other words, reacts easily to even light of a low radiant energy. In that sense, the liquid photo-curable resin is often instable in photochemical reactivity.

In addition, in the case of using a visible radiation curable resin in the photo-molding, a liquid photo-curable resin that is still fresh and remains in a pot of an optical molding apparatus is incidentally exposed to radiant energy when an product consisting of integrally laminated cured resin layers is lifted out from the optical molding apparatus. This exposure possibly causes disordered curing reactions of the liquid photo-curable resin. In order for the fresh liquid photo-curable resin in the pot to be exposed to as less radiant energy as possible for the purpose of avoiding an occurrence of such a disordered curing reaction and realizing well controlled in curing dimensions, i.e. depth or thickness and width, of the liquid photo-curable resin, it is necessary for the optical molding to be accompanied by a controlled fluid level method which is generally achieved by a complicated and expensive mechanism, or otherwise it is necessary to withdraw the fresh liquid photo-curable resin from the pot and to keep it from exposure to damaging radiant energy after having built up a product.

Alternatively, it is necessary for the visible radiation curable resins to be previously colored so as thereby to make radiant energy to which the photo-initiator is exposed as low in intensity as possible. In this instance, a product made of the visible radiant curable resin in optical molding is significantly poor in transparency and is inept in application to models for visualization and/or verification of fit.

In addition, as compared with ultraviolet curable resins, the visible radiation curable resin must be handled with particular care in order to prevent it from being undesirably exposed to damaging radiations.

It is therefore an object of the present invention to provide a photo-curable resin composition for use in optical molding that is suitable for forming a cured resin layer with well controlled thickness and width and thereby building up a precise stacked integral laminae of cured resin as a three-dimensional product.

It is another object of the present invention to provide a photo-curable resin composition for use in optical molding for building up a three-dimensional product that is curable with radiant energy whose wavelengths range from approximately 330 nm to 500 nm

The inventor of this application has conducted the sturdy of photo-curable resin compositions that are suitably used in a downsized and price-reduced optical molding apparatus to form a cured resin layer with well controlled thickness and width thereby building up a precise stacked integral laminae of cured resin as a three-dimensional product even when the photo optical molding apparatus is equipped with a radiant energy source producing radiation whose wavelength ranging from an ultraviolet range to a visible range. As a result of the sturdy, it was revealed found that a photo-curable resin composition satisfying the objects is realized by containing a fluorescent brightener of higher than 50% wavelength reflectivity in addition to an ultraviolet radiation absorbable type of photo-initiator whose longest wavelength of absorption is shifted to the visible range.

A photo-curable resin composition obtained based on the founding comprises a photo-curable resin material containing a photo-initiator that causes a curing reaction with radiant energy, such as ultraviolet or visible radiant energy, and a fluorescent brightener of higher than 50% wavelength reflectivity. This photo-curable resin composition in liquid form credibly forms a cured resin layer with controlled dimensions, i.e. thickness and width, and, in consequence, makes it certain to build up a precise stacked integral laminae of cured resin as a three-dimensional product.

The photo-initiator may be of a type causing a curing reaction of the photo-curable resin in liquid form with ultraviolet radiant energy. In this instance, the photo-initiator contains a photo-sensitizer operative to extend wavelengths of absorbable radiant energy of the photo-initiator toward the visible range, e.g. to a wavelength of 500 nm. This photo-curable resin composition supports the actualization of employing mercury lamps capable of producing ultraviolet radiation or laser diodes (LD) capable of producing visible radiant energy (light) as a radiant energy source that are well-adaptable for inexpensive production on a large scale in optical molding apparatuses. Furthermore, the photo-curable resin composition is prevented from causing quantitative deterioration and inducing an occurrence of disordered curing reactions due to exposure to radiant energy in an ultraviolet range that are contained in natural light or fluorescent light and is kept unreactive to radiant energy.

The fluorescent brightener may comprise one or more selected from a group of bistriazinyl aminostil benzisulfonate derivatives, coumarin derivatives, pyrazoline derivatives, naphthalimide derivatives, bisbenzoxazoryle derivatives, bisstilbiphenyl derivatives and triazole derivatives. Further, the photo-sensitizer may comprise either one of thioxanthone and benzophenone initiators.

According to the photo-curable resin composition, quantitative control of radiant energy necessary for dissociation of the photo-initiator is achieved by absorbing radiation in the ultraviolet range (from 330 nm to 400 nm) that is the most intensive among all of radiation emitted from the sun with the photo-initiator and/or the fluorescent-brightener and releasing it as visible radiant energy through transformation of wavelength of the absorbed ultraviolet radiation, by absorbing and reflecting only a slight quantity of visible radiation energy of wavelengths ranging from 400 nm to 420 nm emitted from the sun and reflected, and by an absence of sensitivity of the photo-sensitizer to visible radiation energy of wavelengths over 500 nm, in other words, by rendering the photo-sensitizer insensitive to radiation of wavelengths longer than remaining radiation in a range that is uncalled for in a curing reaction of a liquid of the photo-curable resin composition in liquid form. In addition, intensity control of radiant energy that reaches the photo-initiator is achieved by means of absorption, wavelength transformation and release, and reflection of radiation of wavelengths in the same range as and shorter than radiation to which a liquid of the photo-curable resin composition is exposed for formation of a cured resin layer.

The photo-curable resin composition of the present invention is reactive to a wide range of radiation energy of wavelengths ranging from an ultraviolet range to a visible range and excels in forming a cured resin layer with well controlled thickness and width and thereby building up a precise stacked integral laminae of cured resin as a three-dimensional product. Moreover, since the photo-curable resin composition does not cause self-curing reactions even while it is left exposed to natural light such as fluorescent light in a room for 30 minutes, it is easily handled like the conventional ultraviolet resin compositions.

The above and other objects and features of the present invention will be clearly understood from the following detailed description when read with reference to the accompanying drawings, in which:
Figure 1 is a graphical representation of the relationship of cured dimension relative to fluorescent brightener content of a photo-curable resin composition of Example I for various radiant energy;
Figure 2 is a graphical representation of the relationship of cured dimension relative to fluorescent brightener content of a photo-curable resin composition of Example II for various radiant energy; and
Figure 3 is a graphical representation of the relationship of cured dimension relative to fluorescent brightener content of a photo-curable resin composition of Example III for various radiant energy.

Curing mechanisms of liquid photo-curable resin in optical molding are classified into two groups depending on types of substance released from a photo-initiator contained in a photo-curable resin composition when the photo-curable resin composition is irradiated with radiant energy. Specifically, in the case where a photo-curable resin contains a radical reaction type of photo-initiator, when a liquid of the photo-curable resin is irradiated with radiant energy, the photo-initiator is dissociated to release radicals. The radicals function as a reaction species to induce monomers or oligomers of the liquid photo-curable resin to cause a cross-linking reaction and, as a result of the cross-linking reaction, the liquid photo-curable resin is cured and solidified. On the other hand, in the case where a photo-curable resin contains a radical reaction type of photo-initiator, when a liquid of the photo-curable resin is irradiated with radiant energy, the photo-initiator releases a catalytic component operative to initiate a cationic polymerization. The catalytic component functions as a reaction species to induce monomers or oligomers of the liquid photo-curable resin to cause a cross-linking reaction and, as a result of the cross-linking reaction, the liquid photo-curable resin is cured and solidified. In each case, radiant energy with which the liquid photo-curable resin is irradiated is gradually attenuated on its way from an irradiated surface of the liquid photo-curable resin depending on a wavelength of light and/or composition of photo-curable resin and finally loses necessary intensity for causing a curing reaction. Consequently, a size of cured resin product depends on a total amount of radiant energy and a degree of attenuation of radiant energy, more strictly on an intensity of radiant energy (a threshold level of radiant energy) necessary for the photo-initiator to be dissociated and release radicals or to release a catalytic component and a reach of effect of the radicals or the catalytic component released from the photo-initiator.

As is obvious, when producing a high precision three-dimensional product and, in particular, building up a three-dimensional product with complex overhangs layer-by-layer, the degree of precision depends on an extension of widths in X and/or Y directions and an extension of depth in Z direction of a unit solid body which refers to a cured and solidified body of photo-curable resin per unit area exposure, the smaller the extensions of depth and width, the higher the degree of precision of three-dimensional product. In the case of using radiant energy of wavelengths ranging from 300 nm to 380 nm, it is effective to cause the photo-curable resin to absorb ultraviolet radiation correspondingly to an amount of ultraviolet absorbent added in the photo-curable resin. Accordingly, the degree of precision of a unit solid body of photo-curable resin can be enhanced by controlling the threshold level of radiant energy for dissociation of the photo-initiator through quantitative control of the added amount of ultraviolet absorbent. However, in the case of using radiant energy of wavelengths longer than 400 nm such as visible radiant energy produced by a laser that emits radiation in the visible range of spectrum between 400 nm and 700 nm or in the case of using radiant energy over a wade range of wavelengths ranging from 330 nm to 500 nm such as ultraviolet radiant energy produced by an ultraviolet lamp, it is difficult for the photo-curable resin to absorb the radiant energy of wavelengths longer than 380 nm by the ultraviolet adsorbent added in the photo-curable resin only and, in consequence, the radiant energy of wavelengths longer than 380 nm is in disuse or makes nothing for a photo-curing reaction of the liquid photo-curable resin.

### EXAMPLE I

A primary composition of photo-curable resin (primary photo-curable resin P1) was made up of 20.0 parts by weight of propoxylated trimethylolpropane triacrylate (POTMPTA) in liquid form for a photo-curable resin medium and 0.48 parts by weight of 2-methyl-1-[4-(methylthio)phenyl]-2-morpholinopropane-1-on (one of commercially available examples is IRGACURE 907) for a radical photo-initiator. In order to examine a change of state, i.e. curing reactivity, the liquid primary photo-curable resin P1 was left exposed to natural light such as fluorescent light in a room for 30 minutes. The examination result proved that the liquid primary photo-curable resin P1 induced little curing reaction to the natural light.

A sample composition of photo-curable resin (photo-curable resin S1) was prepared by adding 0.12 parts by weight of isopropyl thioxanthone as a photo-sensitizer to 20.0 parts by weight of the liquid primary photo-curable resin P1. The result of the same examination demonstrated the fact that the liquid photo-curable resin S1 reacted to natural light to cause a slight curing reaction. It was deducible from the fact that the liquid photo-curable resin S1 had reactivity depending on wavelength (wavelength-dependency). In order to confirm the deduction, examinations were conducted to ascertain wavelength-dependency of the liquid photo-curable resin S1 using a commercially available argon laser such as INNOVA 90-6 distributed by Coherent Corporation. Specifically, the liquid photo-curable resins S1 were exposed to argon laser beams of radiant energy of 25 mW at a wavelength of 457.9 nm, radiant energy of 18mW at a wavelength of 488.0 nm and radiant energy of 15 mW at a wavelength of 514.5 nm, respectively, for 10 seconds. The result of the examinations demonstrated that the liquid photo-curable resin S1 was reactive to the argon laser beam at a wavelength of 457.9 nm but not reactive to the argon laser beam at a wavelength of 488.0 nm nor at a wavelength of 514.5 nm.

Curing experiment was performed in order to verify whether the liquid photo-curable resin S1 was reactive to visible radiant energy of comparatively low intensity. Specifically, the curing experiment was performed by building up a solid body by exposing the liquid photo-curable resin S1 to a visible radiation single mode laser beam of a width of 40 µm and radiant energy ranging 3 mW to 7 mW at a wavelength of 405 nm for ten seconds. Used as a radiant energy source in the curing experiments was a commercially available laser diode such as NLHV3000 distributed by Nichia Corporation. The result of the curing experiments is shown in Table I below.

**TABLE I**

| Laser Output (mW) | Cured Depth (µm) | Cured width (µm) |
|---|---|---|
| 7 | 1723 | 237 |
| 6 | 1580 | 234 |
| 5 | 1492 | 202 |
| 4 | 1435 | 177 |
| 3 | 844 | 166 |

The result clearly shows the fact that the liquid photo-curable resin S1 is reactive sufficiently to visible radiant energy of comparatively low intensity such as produced by a laser diode.

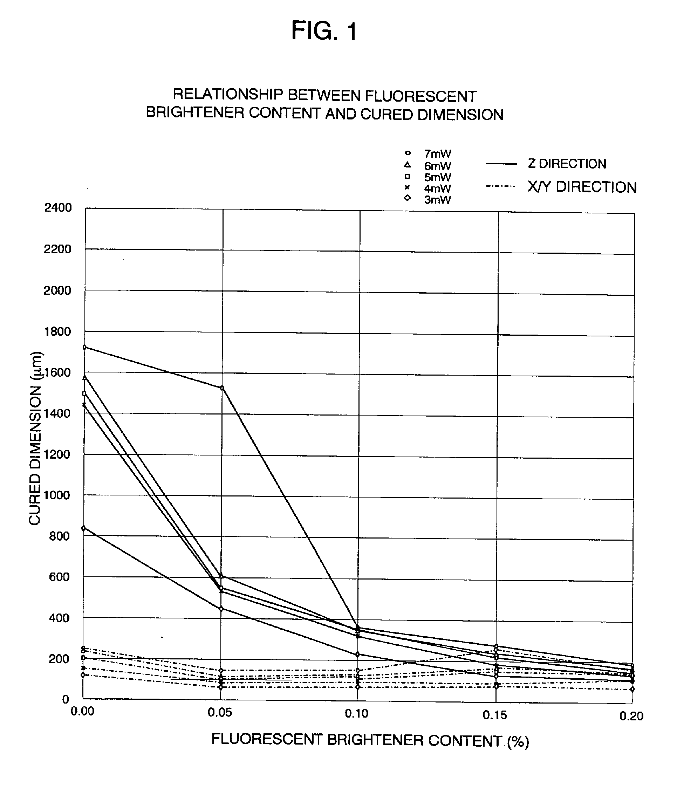

It was revealed that a fluorescent brightener was useful for improving the curing and solidification effect of the liquid photo-curable resin S1. In order to examine the curing and solidification effect of the photo-curable resin S1 added with 2,5-bis[5-t-butylbenzoxazoryle (2)] thiophene, (one of commercially available examples is UVITEX-OB), which is one of bisbenzoxazoryle derivatives, as a fluorescent brightener, the same curing experiment as above was performed for fluorescent brightener contents of 0.01 parts (0.05%) by weight, 0.02 parts (0.10%) by weight, 0.03 parts (0.15%) by weight, 0.04 parts (0.20%) by weight and 0.05 parts (0.25%) by weight per 20.0 parts of the liquid primary photo-curable resin P1. Because the liquid photo-curable resin S1 added with 0.05 parts by weight of 2,5-bis[5-t-butylbenzoxazoryle (2)] thiophene was almost insoluble under a room temperature and no solid body was estimated. The result is shown in Figure 1 and Table II below

**TABLE II**

| Laser Output (mW) | Fluorescent Brightener in Photo-Curable Resin S1 | | | | | | | | | |
|---|---|---|---|---|---|---|---|---|---|---|
| | Non | | 0.01 part | | 0.02 parts | | 0.03 parts | | 0.04 parts | |
| | Cured Depth (µm) | Cured width (µm) | Cured Depth (µm) | Cured width (µm) | Cured Depth (µm) | Cured width (µm) | Cured Depth (µm) | Cured width (µm) | Cured Depth (µm) | Cured width (µm) |
| 7 | 1723 | 237 | 1528 | 132 | 359 | 144 | 272 | 233 | 187 | 170 |
| 6 | 1580 | 234 | 607 | 111 | 357 | 126 | 224 | 157 | 174 | 161 |
| 5 | 1492 | 202 | 542 | 104 | 358 | 120 | 220 | 145 | 160 | 143 |
| 4 | 1435 | 177 | 539 | 90 | 330 | 98 | 181 | 98 | 135 | 121 |
| 3 | 844 | 166 | 442 | 72 | 225 | 75 | 124 | 84 | 121 | 75 |

It is clearly revealed from the result that a fluorescent brightener such as bisbenzoxazoryle derivatives shows marked improvement of the precision of curing and solidification depth and width of the photo-curable resin S1.

### EXAMPLE II

A primary composition of photo-curable resin (primary photo-curable resin) P2 was made up of 20.0 parts by weight of propoxylated trimethylolpropane triacrylate (POTMPTA) in liquid form for a photo-curable resin medium and 0.48 parts by weight of 2-hydroxy-2-methyl-1-phenyl- propane-1-on (one of commercially available examples is Darocure-1173) for a radical photo-initiator. As a result of the same examination as conducted for the primary photo-curable resin P1, it was proved that the liquid primary photo-curable resin P2 did not cause a curing reaction to the natural light at all.

A sample of photo-curable resin (photo-curable resin S2) was prepare by adding 0.12 parts by weight of isopropyl thioxanthene as a photo-sensitizer to 20.0 parts by weight of the liquid primary photo-curable resin P2. The result of the same examination demonstrated the fact that the liquid photo-curable resin S2 showed no curing reaction.

As a result of the same examination regarding wavelength-dependency as conducted for the photo-curable resin S1 it was ascertained that the liquid photo-curable resin S2 was unreactive to the argon laser beam of wavelengths ranging from 457.9 nm to 514.5 nm.

Therefore, the same curing experiments as above were performed in order to verify whether the liquid photo-curable resin S2 was reactive to visible radiant energy of comparatively low intensity. The result of the curing experiments is shown in Table III below.

**TABLE III**

| Laser Output (mW) | Cured Depth (µm) | Cured width (µm) |
|---|---|---|
| 6 | 1949 | 114 |
| 5 | 1542 | 105 |
| 4 | 1328 | 70 |

The result clearly shows the fact that the liquid photo-curable resin S2 is reactive sufficiently to visible radiant energy of comparatively low intensity such as produced by a laser diode.

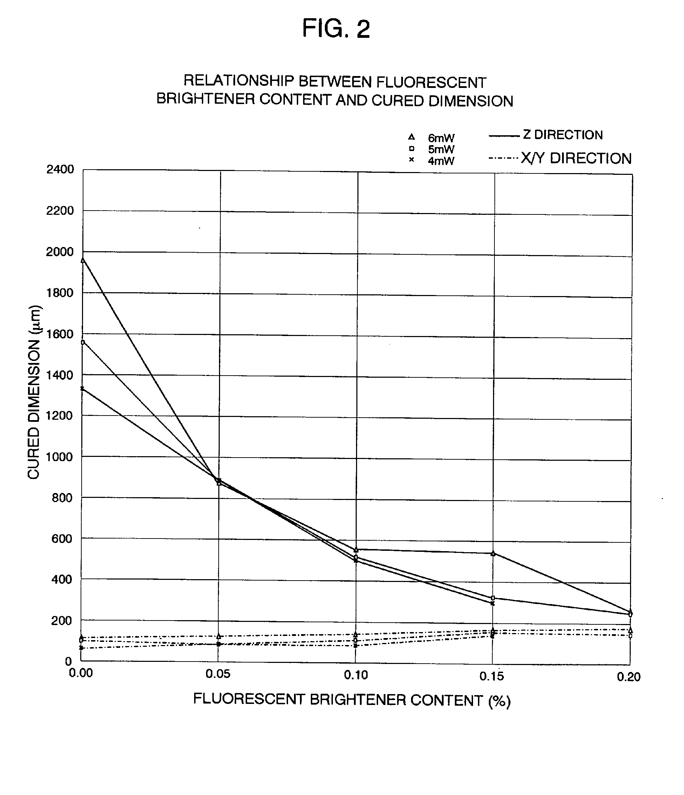

Further, the same curing experiment as above was performed for the liquid photo-curable resin S2 added with a fluorescent brightener, e.g. 2,5-bis[5-t-butylbenzoxazoryle (2)] thiophene (UVITEX-OB) for fluorescent brightener contents of 0.01 parts (0.05%) by weight, 0.02 parts (0.10%) by weight, 0.03 parts (0.15%) by weight, 0.04 parts (0.20%) by weight and 0.05 parts (0.25%) by weight per 20.0 parts of the liquid primary photo-curable resin P2. Because the photo-curable resin S2 with 0.05 parts of 2,5-bis[5-t-butylbenzoxazoryle (2)] thiophene was almost insoluble under a room temperature and no solid body was estimated. The result is shown in Figure 2 and Table IV below

**TABLE IV**

| Laser Output (mW) | Fluorescent Brightener in Photo-Curable Resin S2 | | | | | | | | | |
|---|---|---|---|---|---|---|---|---|---|---|
| | Non | | 0.01 part | | 0.02 parts | | 0.03 parts | | 0.04 parts | |
| | Cured Depth (µm) | Cured width (µm) | Cured Depth (µm) | Cured width (µm) | Cured Depth (µm) | Cured width (µm) | Cured Depth (µm) | Cured width (µm) | Cured Depth (µm) | Cured width (µm) |
| 6 | 1949 | 114 | 1868 | 120 | 565 | 136 | 49 | 142 | 254 | 148 |
| 5 | 1542 | 105 | 880 | 89 | 516 | 110 | 338 | 141 | 241 | 135 |
| 4 | 1328 | 79 | 680 | 89 | 500 | 90 | 317 | 129 | -- | -- |

It is clearly revealed from the result that bisbenzoxazoryle derivatives as a fluorescent brightener provides marked improvement of the precision of curing and solidification depth and width of the photo-curable resin S2.

### EXAMPLE III

A primary composition of photo-curable resin (primary photo-curable resin) P3 was made up of 20.0 parts by weight of propoxylation trimethylolpropane triacrylate (POTMPTA) for a photo-curable resin medium and 0.48 parts by weight of 2-benzyl-2-dimethylamino-1-(4-molyfolinophenyl)-butanone-1 (one of commercially available examples is IRGACURE-1173) for a radical photo-initiator. As a result of the same examination as conducted for the liquid primary photo-curable resin P3, it was confirmed that the liquid primary photo-curable resin P3 starts to cause a curing reaction to the natural light after a 10 minutes exposure to the natural light.

Therefore, differently from the liquid photo-curable resins S1 and S2, the same examination regarding wavelength-dependency as above was conducted for the liquid primary photo-curable resin P3. The examination result proved that the liquid primary photo-curable resin P3 caused a curing reaction to the argon laser at a wavelength of 514.5 nm but was unreactive to the argon laser at a wavelength of 457.9 nm nor at a wavelength of 488.0 nm. Further, the same curing experiments as above was performed in order to verify whether the liquid primary photo-curable resin P3 was reactive to visible radiant energy of comparatively low intensity. The result of the curing experiments is shown in Table V below.

**TABLE V**

| Laser Output (mW) | Cured Depth (µm) | Cured width (µm) |
|---|---|---|
| 6 | 2418 | 74 |
| 5 | 2351 | 66 |
| 4 | 1757 | 46 |

The result clearly shows the fact that the primary photo-curable resin P3 is reactive sufficiently to visible radiant energy of comparatively low intensity such as produced by a laser diode.

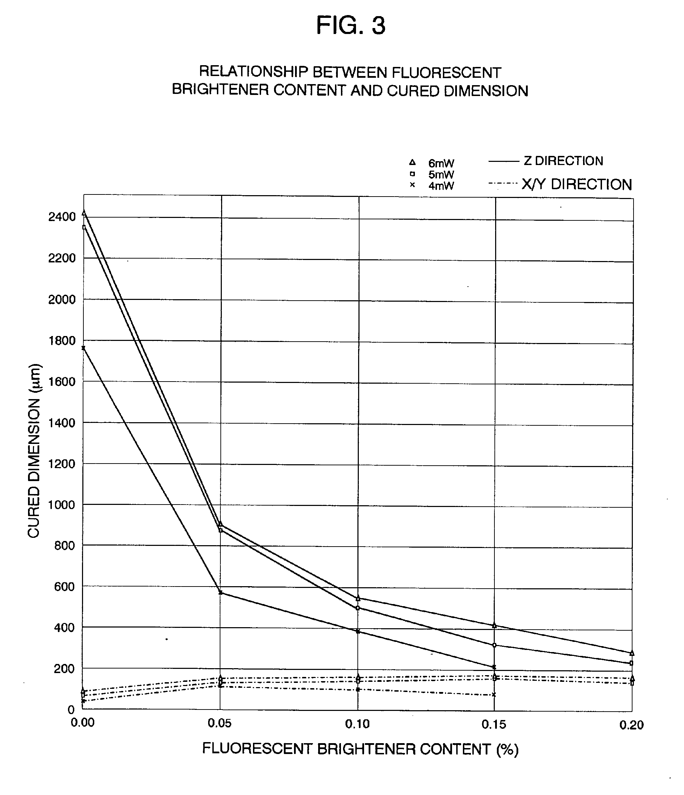

Samples of photo-curable resin (photo-curable resin S3) were prepared by adding different quantities of a fluorescent brightener, e.g. 2,5-bis[5-t-butylbenzoxazoryle (2)] thiophene (UVITEX-OB) to the liquid primary photo-curable resin P3. The same curing experiment as above was performed for fluorescent brightener contents of 0.01 parts (0.05%) by weight, 0.02 parts (0.10%) by weight, 0.03 parts (0.15%) by weight, 0.04 parts (0.20%) by weight and 0.05 parts (0.25%) by weight per 20.0 parts by weight of the liquid primary photo-curable resin P3. Because the photo-curable resin S1 with 0.05 parts of 2,5-bis[5-t-butylbenzoxazoryle (2)] thiophene was almost insoluble under a room temperature and no solid body was estimated. The result is shown in Figure 3 and Table VI below

**TABLE VI**

| Laser Output (mW) | Fluorescent Brightener in Photo-Curable Resin S3 | | | | | | | | | |
|---|---|---|---|---|---|---|---|---|---|---|
| | Non | | 0.01 part | | 0.02 parts | | 0.03 parts | | 0.04 parts | |
| | Cured Depth (µm) | Cured width (µm) | Cured Depth (µm) | Cured width (µm) | Cured Depth (µm) | Cured width (µm) | Cured Depth (µm) | Cured width (µm) | Cured Depth (µm) | Cured width (µm) |
| 6 | 2418 | 74 | 912 | 130 | 556 | 149 | 425 | 155 | 285 | 145 |
| 5 | 2351 | 66 | 874 | 121 | 512 | 129 | 327 | 142 | 252 | 129 |
| 4 | 1757 | 46 | 587 | 115 | 385 | 94 | 315 | 80 | -- | -- |

It is clearly revealed from the result that bisbenzoxazoryle derivatives as a fluorescent brightener provides marked improvement of the precision of curing and solidification depth and width of the photo-curable resin S2.

In the respective examples I, II and III, the bisbenzoxazoryle derivative such as 2,5-bis[5-t-butylbenzoxazoryle (2)] thiophene that is used as a fluorescent brightener may be replaced with various compounds of, for example, bistriazinylamino stilbenzisulfonate derivatives, coumarin derivatives, pyrazoline derivatives, naphthalimide derivatives, bisbenzoxazoryle derivatives, bisstilbiphenyl derivatives or triazole derivatives, individually or in combination. Further, a benzophenone sensitizer such as a diphenyl-(2,4,6-trimethylbenzoyl) phosphine oxide may be used in place of the thioxanthone initiator such as isopropyl thioxanthone.

## Claims

1. A photo-curable resin composition for use in optical molding for building up a three-dimensional product by scanning a surface of a liquid photo-curable resin with a light beam of radiant energy comprising a photo-curable resin material and a photo-initiator contained in said photo-curable resin material that is capable of inducing said photo-curable resin to cause a curing reaction with said radiant energy, **characterized by** a fluorescent brightener contained in said photo-curable resin material.

2. A photo-curable resin composition as defined in claim 1, **characterized in that** said fluorescent brightener comprises at lease one selected from a group of compounds of bistriazinylamino stilbenzosulfonic acid derivatives, coumarin derivatives, pyrazoline derivatives, naphthalimide derivatives, bisbenzoxazoryle derivatives, bisstilbiphenyl derivatives and trizole derivatives.

3. A photo-curable resin composition as defined in claim 1 or 2, **characterized in that** said photo-initiator causes said curing reaction of said photo-curable resin material with radiant energy whose wavelengths are within both ultraviolet and visible ranges.

4. A photo-curable resin composition as defined in claim 3, **characterized in that** said photo-initiator is of a type absorbing ultraviolet radiant energy of wavelengths ranging from approximately 300 nm and contains a photo-sensitizer that causes said photo-initiator to absorb visible radiant energy of wavelengths ranging to approximately 500 nm.

5. A photo-curable resin composition as defined in claim 4, **characterized in that** said photo-sensitizer is either one of a thioxanthone initiator and a benzophenone initiator.

6. A photo-curable resin composition as defined in claim 5, **characterized in that** said photo-sensitizer comprises isopropyl thioxanthone.

7. A photo-curable resin composition as defined in claim 5, **characterized in that** said photo-sensitizer comprises diphenyl-(2,4,6-trimethylbenzoyl) phosphine oxide.
